# EUROPEAN PATENT APPLICATION

(11) **EP 1 376 790 A1**
(43) Date of publication of application: **02.01.2004**
(21) Application number: 02254555.2
(22) Date of filing: 28.06.2002
(51) Int. Cl.: H01S 5/14, G02B 6/16

(54) **Tunable laser wavelength locker**

(71) Applicant: Agilent Technologies, Inc., a corporation of the State of Delaware, Palo Alto, CA 94303-0870 (US)
(72) Inventor: Meadowcroft, Simon, Stowmarket, Suffolk IP14 1TU (GB)
(74) Representative: Coker, David Graeme

(57) **Abstract**

A tunable laser wavelength locker (1) is formed by a Bragg grating (10) provided in an optical fibre (2) or planar waveguide made of relatively high temperature expansion coefficient material. The grating (10) is formed of alternate areas (8, 9) of higher and lower refractive index, and a heating film (13) is provided, for example by deposition, adjacent the grating (10) for adjusting the temperature of the optical fibre (2) so as to cause it to expand or contract, thereby changing the wavelength of light that is reflected back into a tunable laser (6) to "lock" the light emitted from the laser into a communications fibre to that particular wavelength. By having the grating (10) formed in material of high temperature expansion coefficient, a relatively large tuning range can be achieved by a temperature differential of about 80°C.

## Description

The present invention relates to a tunable laser wavelength locker, and to a system for locking an output wavelength of a tunable laser to a desired wavelength.

In a fibre-optic network, the wavelength of light used to communicate a signal is an important parameter. In particular, where Wavelength Division Multiplexing (WDM) systems are employed, different signals are communicated using respectively different wavelengths. Consequently, it is important to maintain the different wavelengths accurately in relation to components of the WDM system, for example multiplexers and demultiplexers, which add or remove wavelengths from the WDM system.

Typically, a semiconductor laser device is employed in a transmitter unit of the fibre-optic network. In order to maintain the output of the laser at the desired wavelength, it must be locked onto that correct wavelength of light to be transmitted by the laser device. As is well known, one way of so locking a laser is to stimulate it with light of the desired wavelength so that it emits substantially all of its light at that wavelength.

A known apparatus for providing light at the desired wavelength to be transmitted into the laser includes a Bragg grating formed in an optical fibre. The grating is formed in the fibre by doping adjacent areas of the fibre with a photosensitive dopant to change the refractive index of those areas so as to form alternate areas of relatively lower and relatively higher refractive index. As is well known, after doping, the fibre is irradiated with UV light to "fix" the change in refractive index of the particular areas. As in a diffraction grating, the alternate areas of higher and lower refractive index will preferentially reflect or transmit light of different wavelengths causing interference between the light reflected from different areas so that only one wavelength is reflected by the grating.

In a known system, a laser is arranged to emit light from a forward active region into an optical fibre for communication. A rear region of the laser passes light of all wavelengths into an optical fibre having the Bragg grating formed therein. The Bragg grating reflects only one wavelength back into the laser, which then locks onto that wavelength and transmits light at that very well defined wavelength into the communications fibre. Clearly, by arranging for the Bragg grating to reflect the correct desired wavelength of light into the laser, the laser will then emit that particular wavelength for communications purposes. This is usually achieved by putting the fibre into tension or compression in order to select the desired wavelength.

However, as optical communication systems become more complicated, and it becomes desirable to utilise more separate wavelength channels, lasers that are not single wavelength are becoming more prevalent since it is easier to tune them to operate at another wavelength than to replace them by another laser operating at the different wavelength. These tunable lasers often have a tunable range of approximately 30 - 40 nm. Since the fibre having the grating is made of fused silica glass, such a conventional Bragg grating fibre cannot provide sufficient tuning range.

Therefore, according to a first aspect of the present invention, there is provided a tunable laser wavelength locker comprising a light transmitting material of relatively high temperature expansion coefficient, the material having a grating formed therein of alternate areas of higher and lower refractive index, and means adjacent the grating for adjusting the temperature of the light transmitting material so as to cause it to expand or contract.

In a preferred embodiment, the light transmitting material is a high refractive index glass, which may be a boro-silicate glass. Alternatively, the light transmitting material is a plastics material.

Preferably, the grating is formed in the light transmitting material by doping it with a photosensitive material in at least some of the alternate areas to change the refractive index of the doped areas.

The light transmitting material preferably forms at least part of an optical fibre.

The means for adjusting the temperature of the light transmitting material preferably comprises a heater deposited on the light transmitting material adjacent the grating.

According to a second aspect, the invention provides a tunable laser system comprising a tunable laser having a first active output region and a second active region, a communications optical fibre having an input end aligned to the first active output region of the laser, and a tunable laser wavelength locker, as described above, aligned to the second active region, and means for controlling the temperature adjusting means adjacent the grating so as to cause the grating to expand or contract in order to reflect only a particular desired wavelength into the second active region of the laser.

In a preferred embodiment, the controlling means is coupled to a controller for receiving information as to the wavelength of light output from the first active output region of the laser into the communications optical fibre.

One embodiment of the invention will now be described, by way of example only, with reference to the accompanying drawings in which:-
FIG. 1 is a schematic diagram of an optical fibre having a Bragg grating formed therein according to an embodiment of the present invention;
FIG. 2 is a schematic drawing of a system for locking an output wavelength of a tunable laser utilising the optical fibre grating of FIG. 1.

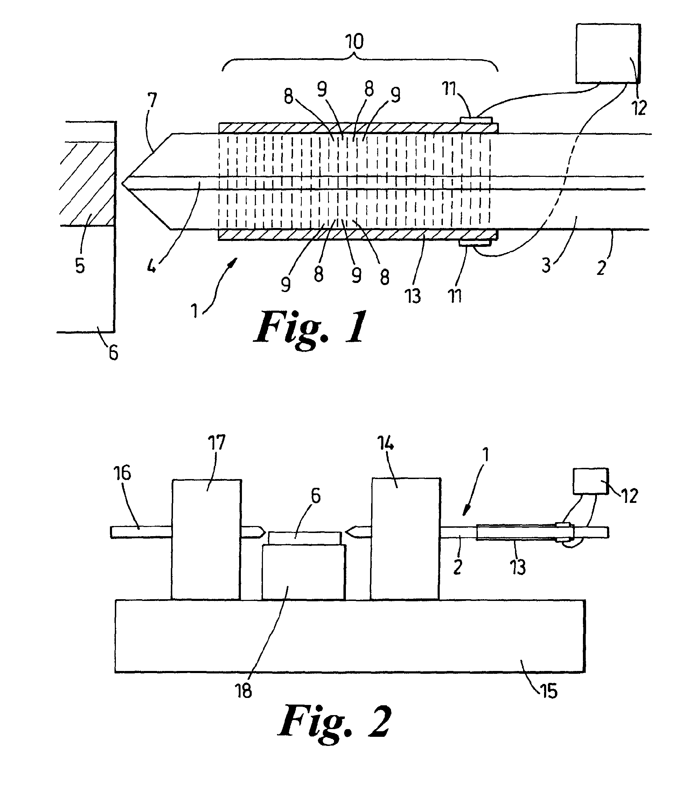

Referring to FIG. 1, a fibre grating 1 comprises an optical fibre 2 having a cladding 3 surrounding a core 4, the core 4 having a higher refractive index than the cladding 3, as is well known. However, instead of the fibre being made of fused silica, as are most known optical fibres, the fibre 2 is formed of a high temperature expansion coefficient material, such as a boro-silicate glass.

Fused silica has a relatively low temperature expansion coefficient, of the order of 0.5 ppm/°C, which equates to a wavelength sensitivity of approximately 0.075nm/°C, giving a tuning range of no more than about 0.6nm over a temperature range of 80°C. By contrast, for example, a lead doped high refractive index glass, may have a temperature expansion coefficient of about 9 ppm/°C, giving a tuning range of about 10-15nm over a temperature range of 80°C, and a plastics material of high temperature expansion coefficient could have a temperature expansion coefficient of 30-40 ppm/°C giving a tuning range of more than 50nm over a temperature range of 80°C.

The optical fibre 2 is aligned with an active region 5 of a laser device 6, as is well known, and has its input end 7 tapered to provide a larger core area for light from the laser active region 5 to enter the core 4.

In order to provide the Bragg grating 10 in the fibre 2, the fibre is selectively doped with photosensitive material, such as Germanium, in order to produce alternate areas 8 and 9 of higher and lower refractive index, when irradiated with ultraviolet (UV) light to "cure" the areas, so that their refractive index remains higher and lower, respectively. This technique is well known and will not be further described here.

A resistive film 13, for example of titanium oxide, is then deposited around the grating, with electrodes 11 being connected to a electrical power controller 12, which can adjust the power provided to the film 13, thereby adjusting the heat given out by the film.

The areas 8 and 9 of alternate high and low refractive index provide a grating 10 which transmits most of the light received from the laser 6 and reflects only one particular wavelength back into the active region 5. The wavelength of the reflected light is, of course, dependent on the spacing of the areas 8 and 9. Therefore, by adjusting the heat given out by the film 13, the spacing of the areas 8 and 9 is adjusted so that the wavelength of the reflected light is changed.

FIG. 2 shows the fibre grating 1 mounted in a first fibre mount 14 attached to a laser module base 15. A communications fibre 16 is similarly mounted in a second fibre mount 17 attached to the laser module base 15 and the laser device 6 is mounted on a laser mount 18 attached to the laser module base 15 between the two fibre mounts 14 and 16. The two fibre mounts 14 and 16 and the laser mount 18 are arranged on the laser module base 15 such that the respective ends of the fibres 16 and 2 are adjacent, and aligned with, active regions on both sides of the laser device 6. As described above, the laser device 6 emits light into the fibre grating 1, which is adjusted to reflect back into the active region of laser device 6 light of the desired wavelength. The laser device 6 then "locks" onto that wavelength of light and emits light at that wavelength into the communications fibre 16, which has a tapered end for receiving the light for the reason described above, to be used for the signalling network, as is well known.

It will be appreciated that although only one particular embodiment of the invention has been described in detail, various modifications and improvements can be made by a person skilled in the art without departing from the scope of the present invention. For example, although the Bragg grating has been described as being formed in an optical fibre, it will be appreciated that it could be formed in other optical components, for example, a planar waveguide, if desired. Furthermore, the power controller could be coupled in a feedback loop to a sensor that senses the output wavelength of the laser, so that the controller can automatically adjust the heat emitted by the heater to maintain the output light at the desired wavelength.

## Claims

1. A tunable laser wavelength locker (1) comprising a light transmitting material of relatively high temperature expansion coefficient, the material having a grating (10) formed therein of alternate areas (8, 9) of higher and lower refractive index, and means (13) adjacent the grating (10) for adjusting the temperature of the light transmitting material so as to cause it to expand or contract.

2. A tunable laser wavelength locker according to claim 1, wherein the light transmitting material is a high refractive index glass.

3. A tunable laser wavelength locker according to claim 2, wherein the high refractive index glass is a boro-silicate glass.

4. A tunable laser wavelength locker according to claim 1, wherein the light transmitting material is a plastics material.

5. A tunable laser wavelength locker according to any preceding claim, wherein the grating (10) is formed in the light transmitting material by doping it with a photosensitive material in at least some of the alternate areas to change the refractive index of the doped areas.

6. A tunable laser wavelength locker according to any preceding claim, wherein the light transmitting material forms at least part of an optical fibre (2).

7. A tunable laser wavelength locker according to any preceding claim, wherein the means (13) for adjusting the temperature of the light transmitting material comprises a heater deposited on the light transmitting material adjacent the grating (10).

8. A tunable laser system comprising a tunable laser (6) having a first active output region and a second active region (5), a communications optical fibre (16) having an input end aligned to the first active output region of the laser (6), and a tunable laser wavelength locker (1) according to any preceding claim aligned to the second active region (5), and means (12) for controlling the temperature adjusting means (13) adjacent the grating (10) so as to cause the grating (10) to expand or contract in order to reflect only a particular desired wavelength into the second active region (5) of the laser (6).

9. A system for tuning a tunable laser according to claim 9, wherein the controlling means (12) is coupled in a feedback path including a sensor for receiving information as to the wavelength of light output from the first active output region of the laser into the communications optical fibre.
